# FASCICULE DE BREVET EUROPEEN

(11) **EP 0 735 551 B1**
(45) Date de publication et mention de la délivrance du brevet: **27.02.2002**
(21) Numéro de dépôt: 96400640.7
(22) Date de dépôt: 27.03.1996
(51) Int. Cl.: H01F 27/28, H01F 27/22

(54) **Assemblage de transformateur, notamment pour un dispositf d'alimentation de lampe à décharge de projecteur de véhicule automobile**
Transformatoreinrichtung, insbesondere für eine Versorgungseinrichtung von Entladungslampen in Kraftfahrzeugen
Transformer assembly, in particular for a supply device of a vehicle discharge lamp

(30) Priorité: 29.03.1995 FR 9503718
(43) Date de publication de la demande: 02.10.1996
(73) Titulaire: VALEO ELECTRONIQUE, 94000 Creteil (FR)
(72) Inventeur: Cassese, Bruno, 94000 Creteil (FR); Wacheux, Patrick, 94800 Villejuif (FR); Paul, Gilles, 92260 Fontenay aux Roses (FR); Nicolai, Jean-Marc, 92400 Courbevoie (FR); Herzberger, Eric, 93220 Gagny (FR)
(74) Mandataire: Le Forestier, Eric

(56) Documents cités:
- EP-A- 0 126 169
- EP-A- 0 354 121
- EP-A- 0 507 360
- EP-A- 0 564 315
- DE-A- 4 001 840
- DE-C- 741 722
- GB-A- 2 252 208
- US-A- 4 873 757
- US-A- 5 210 513
- PATENT ABSTRACTS OF JAPAN vol. 017, no. 480 (E-1425), 31 Août 1993 & JP-A-05 121239 (MATSUSHITA ELECTRIC IND CO LTD), 18 Mai 1993,

## Description

La présente invention est relative à un assemblage de transformateur, notamment pour un dispositif d'alimentation de lampe à décharge de véhicule automobile.

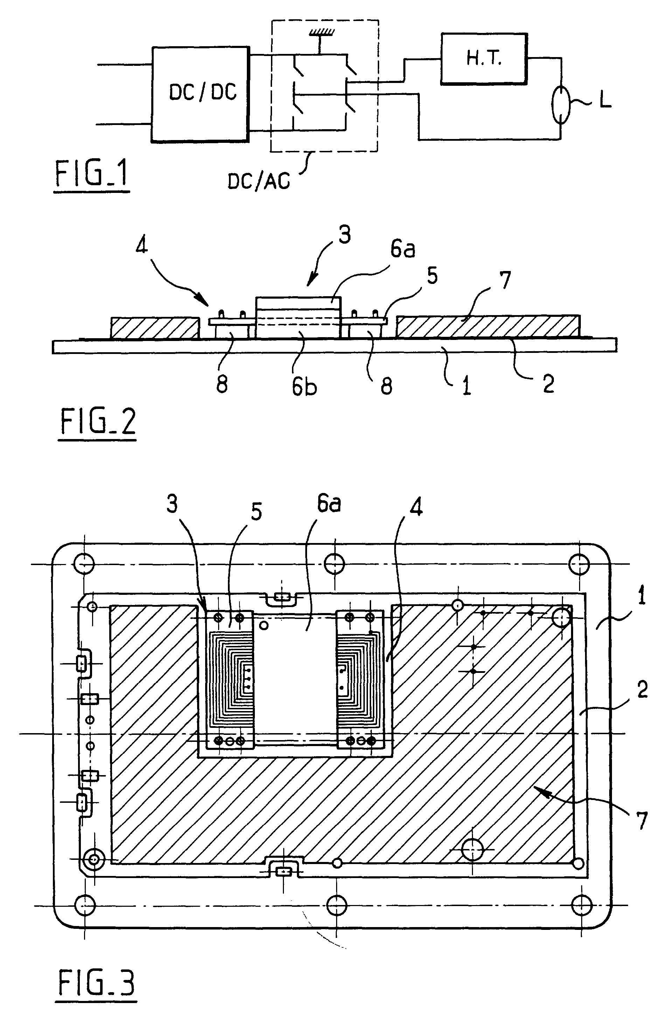

On a représenté schématiquement sur la figure 1 un circuit d'alimentation de lampe à décharge classiquement connu. La lampe à décharge, référencée par L, y est montée en série avec un module HT pour la génération d'une impulsion d'amorçage Haute Tension et est alimentée en tension par un convertisseur continu/alternatif (DC/AC-pont en H) en aval d'un convertisseur continu/continu (DC/DC) - transformateur recevant en entrée la tension (12 V) de la batterie B du véhicule.

Ce convertisseur continu/continu génère toutes les tensions autres que celle de l'impulsion d'amorçage. En particulier, il doit être capable de fournir pour le démarrage une tension élevée de 500 V pendant plusieurs millisecondes.

Les transformateurs utilisés à ce jour dans les convertisseurs continu/continu alimentant les lampes à décharge de projecteur de véhicule automobile sont de ce fait relativement volumineux.

Or, on cherche actuellement à réduire considérablement l'encombrement des circuits d'alimentation des lampes à décharge de façon à pouvoir les loger totalement dans les projecteurs, alors que jusqu'à présent les convertisseurs des circuits d'alimentation étaient à l'extérieur.

On connaît déjà, notamment par US 4 873 757, des transformateurs de petites dimensions dont les enroulements sont constitués par un circuit imprimé multicouche et dont les ferrites sont constituées par deux ferrites en E refermées l'une sur l'autre et dont les branches traversent les ouvertures du circuit multicouche.

Les ferrites et le circuit multicouche sont rapportés sur un circuit imprimé. A cet effet, les ferrites sont maintenues dans un cerclage métallique qui les entoure partiellement et qui est soudé en deux points sur le circuit imprimé. Ce cerclage métallique assure la mise à la masse des ferrites.

Un tel transformateur n'est toutefois pas satisfaisant.

En particulier, les ferrites ont tendance à s'échauffer fortement, ce qui rend ce type de transformateur incompatible avec certaines applications.

L'invention propose quant à elle une structure qui permet de pallier ces inconvénients.

On connaît déjà par EP 564 315 un assemblage comportant un transformateur à enroulements, ainsi qu'un circuit imprimé sur lequel ledit transformateur est monté et un élément métallique formant drain thermique, ledit transformateur comportant deux éléments en ferrite qui sont refermés l'un sur l'autre.

L'invention propose quant à elle, pour un dispositif d'alimentation d'une lampe à décharge de projecteur de véhicule automobile, un assemblage dans lequel l'élément formant drain thermique est une semelle métallique avec laquelle le circuit imprimé est en contact par sensiblement toute une de ses surfaces, l'un des éléments en ferrite du transformateur présentant un fond en contact sur toute sa surface, avec la face du circuit imprimé qui est opposée à la semelle métallique, l'autre des éléments en ferrite du transformateur étant de forme plate et étant rapporté sur des branches que comportent le premier élément en ferrite et qui s'étendent à partir dudit fond.

Comme on le comprendra aisément, un tel assemblage est un montage simple permettant d'assurer à la fois la dissipation de la chaleur de l'élément ou des éléments en ferrite et la mise à la masse de cet ou de ces éléments.

Avantageusement, une couche intermédiaire adhésive est interposée entre l'ensemble de ladite surface et le circuit imprimé.

L'invention concerne également un dispositif d'alimentation d'une lampe à décharge de véhicule automobile, caractérisé en ce qu'il comporte un tel transformateur.

Elle concerne en outre un projecteur à lampe à décharge de véhicule automobile, caractérisé en ce qu'il comporte un tel dispositif d'alimentation.

D'autres caractéristiques et avantages de l'invention ressortiront encore de la description qui suit. Cette description est purement illustrative et non limitative. Elle doit être lue en regard des dessins annexés sur lesquels :
- la figure 1, déjà analysée, est une représentation schématique d'un dispositif d'alimentation de lampe à décharge de véhicule automobile ;
- la figure 2 est une représentation en coupe d'un assemblage conforme à un mode de réalisation possible pour l'invention ;
- la figure 3 est une vue de dessus d'un assemblage de la figure 2 ;
- les figures 4a à 4d illustrent en vue de dessus, de dessous et de côté des barrettes pour la fixation du transformateur du dispositif des figures 2 et 3 sur le circuit imprimé ;
- les figures 5a à 5f sont des vues de dessus de chacun des différents enroulements de la structure multicouche du transformateur des figures 2 et 3.

Le dispositif illustré sur les figures 2 et 3 comporte une semelle métallique 1, par exemple en aluminium, formant drain thermique qui porte une carte de circuit imprimé 2 sur laquelle est monté un transformateur 3.

Le drain thermique 1 et la carte 2 sont sensiblement rectangulaires. La carte 2 est un circuit imprimé double face pressé à chaud sur le drain thermique 1. Sur sa face opposée au drain thermique 1, elle porte par exemple des composants CMS dans une zone 7 qui entoure le transformateur 3.

Le transformateur 3 est principalement constitué d'un circuit imprimé multicouche 5 et de deux éléments en ferrite 6a et 6b refermés l'un sur l'autre. Celui - référencé par 6a - de ces deux éléments qui est le plus éloigné du drain 1, est de forme plate. L'autre - référencé par 6b - est de forme en E, son fond étant en contact sur toute sa surface, préférentiellement au moyen d'une couche intermédiaire adhésive, avec le circuit imprimé 2, tandis que ses branches traversent la carte 5 multicouche.

Ainsi, le circuit imprimé 2 assure la conduction thermique et électrique des ferrites avec le drain 1.

La couche intermédiaire est, par exemple, constituée par un ruban adhésif double face ou un film de colle.

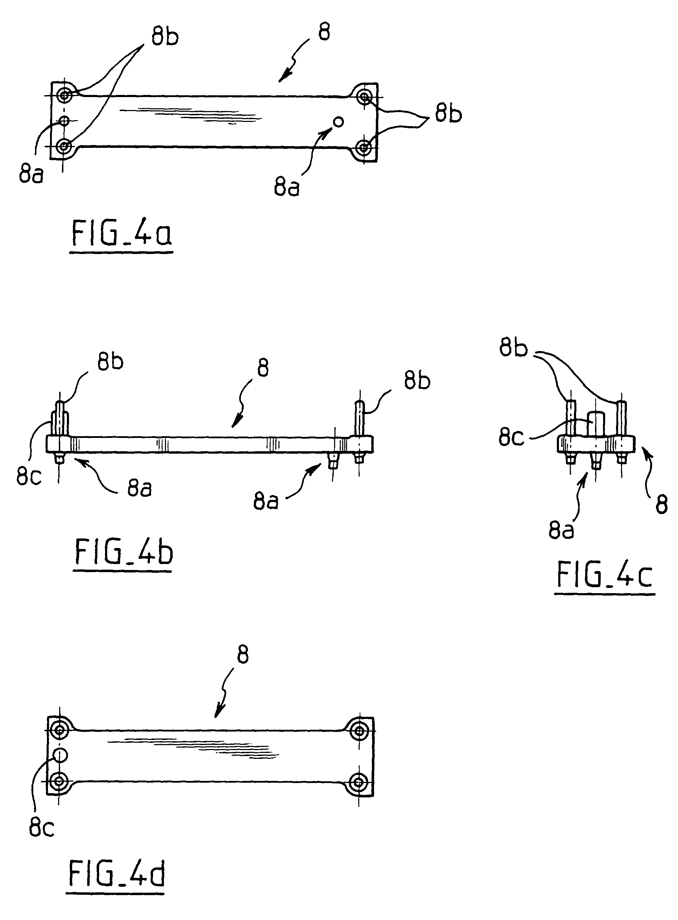

La carte multicouche 5 est fixée sur la carte de circuit imprimé 2 par l'intermédiaire de deux barrettes 8, telles que plus particulièrement représentées sur les figures 4a à 4d.

Chaque barrette 8 est une lame plate qui porte à chacune de ces extrémités d'une part un ou plusieurs pions de positionnement 8a dirigé(s) vers la semelle métallique 1 et d'autre part des broches 8b de contact électriques dirigées vers le circuit multicouche 5. Elle porte également un ou plusieurs pions 8c pour le positionnement du circuit multicouche 5.

Les barrettes 8 sont soudées par exemple à la vague sur le circuit imprimé 2.

Lors du montage, le transformateur 3 est positionné sur une zone cuivrée du circuit 2, le circuit multicouche 5 étant positionné sur les barrettes 8. La couche adhésif permet également de maintenir le transformateur 3 sur le circuit 2 avant le soudage du circuit multicouche 5 sur les broches 8b, opération qui est réalisée manuellement.

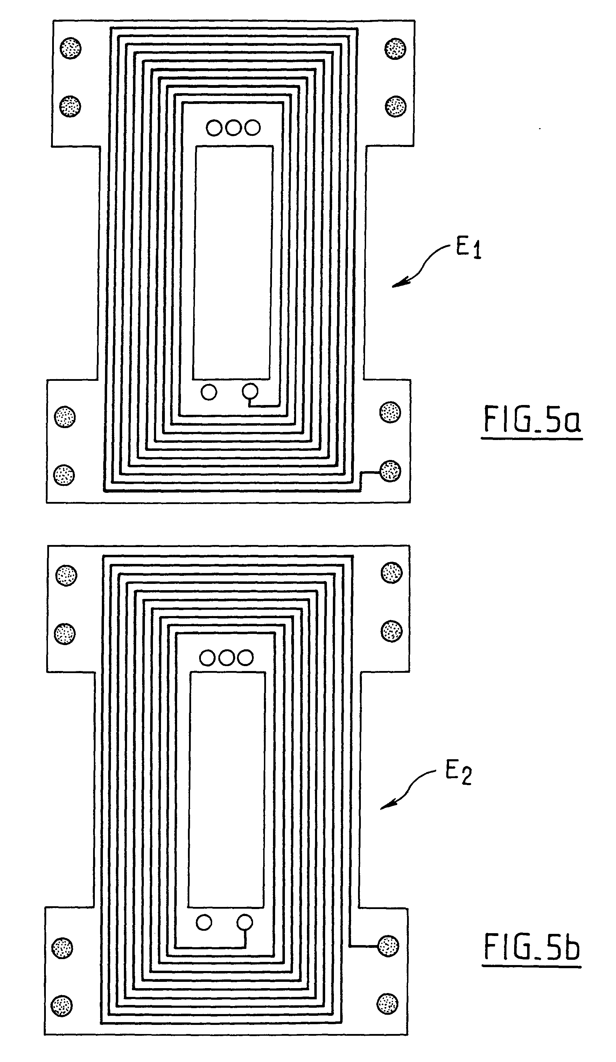

On a illustré sur les figures 5a à 5f les enroulements des différentes couches empilées de la carte multicouche.

Les deux enroulements E1 et E2 supérieurs définissent un premier secondaire du transformateur (figure 5a).

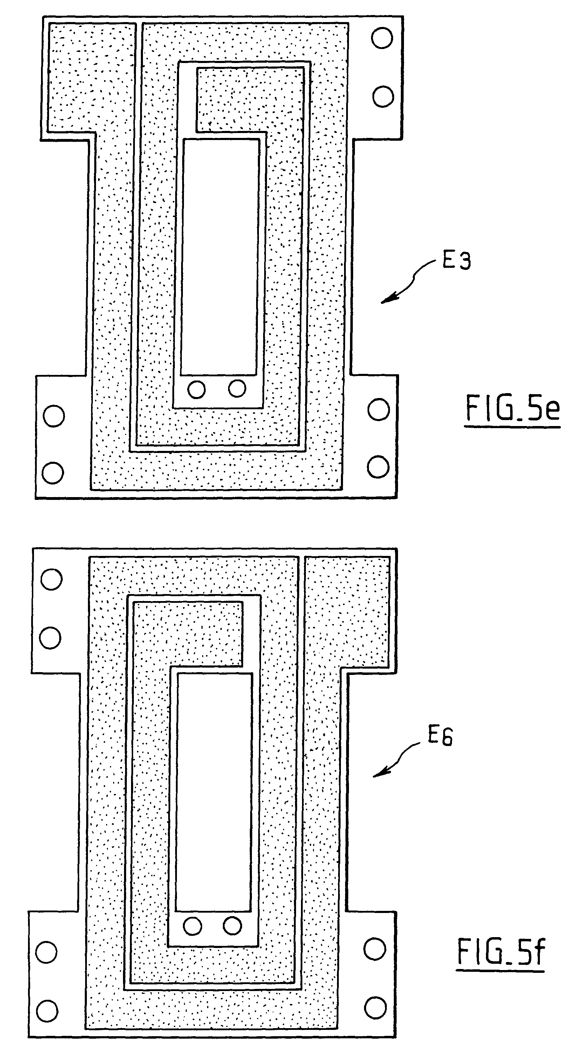

L'enroulement E3 qui suit correspond à l'un des deux enroulements du primaire du transformateur (figure 5e).

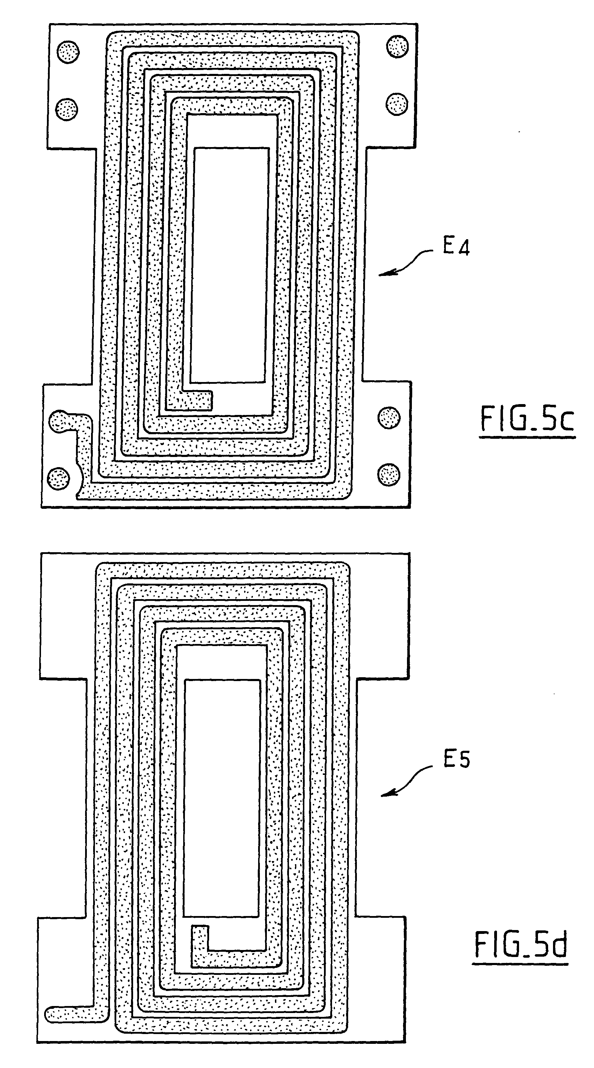

Les deux enroulements E4 et E5 qui suivent définissent un deuxième secondaire du transformateur (figures 5c et 5d).

L'enroulement inférieur E6 (figure 5f) correspond au deuxième enroulement qui définit le primaire du transformateur avec l'enroulement E3.

Comme on peut le constater sur ces figures 5a à 5f, les enroulements E1 et E2 sont chacun de 10 spires, de sorte que le premier secondaire du transformateur est de 20 spires en tout.

Les enroulements E4 et E5 sont chacun de 4 spires, de sorte que le deuxième secondaire du transformateur est au total de 8 spires.

Les deux enroulements E3 et E6 sont tous deux de 2 spires, de sorte qu'au total le primaire est de 4 spires.

Les ferrites utilisées sont par exemple du type de celles commercialisées sous les références 43208EC et 43208EQI par la Société MAGNETICS.

Avec ces ferrites, le transformateur est d'une hauteur de l'ordre de 10 mm.

## Revendications

1. Assemblage comportant un transformateur à enroulements (5 ; 6a, 6b), ainsi qu'un circuit imprimé (2) sur lequel ledit transformateur est monté et un élément métallique formant drain thermique, ledit transformateur comportant deux éléments en ferrite (6a, 6b) qui sont refermés l'un sur l'autre, **caractérisé en ce que**, ledit assemblage étant un assemblage pour un dispositif d'alimentation d'une lampe à décharge de projecteur de véhicule automobile, l'élément formant drain thermique est une semelle métallique (1) avec laquelle le circuit imprimé est en contact par sensiblement toute une de ses surfaces, l'un des éléments en ferrite du transformateur présentant un fond en contact sur toute sa surface, avec la face du circuit imprimé qui est opposée à la semelle métallique, l'autre des éléments en ferrite du transformateur étant de forme plate et étant rapporté sur des branches que comportent le premier élément en ferrite et qui s'étendent à partir dudit fond.

2. Assemblage selon la revendication 1, **caractérisé en ce que** l'élément en ferrite dont le fond est en contact avec un circuit imprimé est un de forme en E.

3. Assemblage selon l'une des revendications 1 ou 2, **caractérisé en ce qu'**une couche adhésive intermédiaire (7) est interposée entre l'ensemble de ladite surface et le circuit imprimé ou la semelle métallique.

4. Assemblage selon la revendication 3, **caractérisé en ce que** la couche intermédiaire (7) est un ruban adhésif double face.

5. Assemblage selon l'une des revendications précédentes, **caractérisé en ce que** la semelle métallique (1) est en aluminium.

6. Dispositif d'alimentation d'une lampe à décharge de véhicule automobile, **caractérisé en ce qu'**il comporte un assemblage selon l'une des revendications précédentes.

7. Projecteur à lampe à décharge de véhicule automobile, **caractérisé en ce qu'**il comporte un dispositif d'alimentation selon la revendication 6.

## Patentansprüche

1. Baugruppe mit einem Transformator mit Wicklungen (5; 6a, 6b) sowie mit einer gedruckten Schaltung (2), auf der der Transformator montiert ist, und einem Metallelement, das eine Wärmesenke bildet, wobei der Transformator zwei Ferritelemente (6a, 6b) aufweist, die gegeneinander geschlossen sind,
**dadurch gekennzeichnet, daß** die Baugruppe eine Baugruppe für eine Vorrichtung zur Stromversorgung einer Entladungslampe eines Kraftfahrzeugscheinwerfers ist, daß das die Wärmesenke bildende Element eine Metallsohle (1) ist, mit der die gedruckte Schaltung auf im wesentlichen einer gesamten ihrer Oberflächen in Kontakt ist, daß eines der Ferritelemente des Transformators einen Boden aufweist, der mit seiner gesamten Fläche die der Metallsohle gegenüberliegende Oberfläche der gedruckten Schaltung berührt, daß das andere Ferritelement des Transformators plattenförmig ist und an den Armen angesetzt ist, die das erste Ferritelement aufweist und die sich von dem Boden aus erstrecken.

2. Baugruppe nach Anspruch 1,
**dadurch gekennzeichnet, daß** das Ferritelement, dessen Boden eine gedruckte Schaltung berührt, E-förmig ist.

3. Baugruppe nach einem der Ansprüche 1 oder 2,
**dadurch gekennzeichnet, daß** eine haftende Zwischenschicht (7) zwischen die Einheit aus der Oberfläche und der gedruckten Schaltung oder der Metallsohle eingefügt ist.

4. Baugruppe nach Anspruch 3,
**dadurch gekennzeichnet, daß** die Zwischenschicht (7) ein doppelseitiges Klebeband ist.

5. Baugruppe nach einem der vorhergehenden Ansprüche,
**dadurch gekennzeichnet, daß** die Metallsohle (1) aus Aluminium besteht.

6. Vorrichtung zur Stromversorgung einer Entlandungslampe eines Kraftfahrzeugs,
**dadurch gekennzeichnet, daß** sie eine Baugruppe nach einem der vorhergehenden Ansprüche umfaßt.

7. Scheinwerfer mit Entladungslampe für Kraftfahrzeuge,
**dadurch gekennzeichnet, daß** er eine Vorrichtung zur Stromversorgung nach Anspruch 6 umfaßt.

## Claims

1. Assembly including a transformer with windings (5; 6a, 6b), and a printed circuit (2) on which the said transformer is mounted and a metallic element forming a heat sink, the said transformer having two ferrite elements (6a, 6b) which are closed on one another, **characterised in that**, the said assembly being an assembly for a device supplying a motor vehicle headlight discharge lamp, the element forming a heat sink is a metallic sole plate (1) with which the printed circuit is in contact through substantially the whole of one of its surfaces, one of the ferrite elements of the transformer having a bottom in contact over all its surface with the face of the printed circuit which is opposite the metallic sole plate, the other one of the ferrite elements of the transformer being flat in shape and being attached to arms on the first ferrite element and which extend from the said bottom.

2. Assembly according to Claim 1, **characterised in that** the ferrite element whose bottom is in contact with the printed circuit is in an E shape.

3. Assembly according to one of Claims 1 or 2, **characterised in that** an intermediate adhesive layer (7) is interposed between all the said surface and the printed circuit or the metallic sole plate.

4. Assembly according to Claim 3, **characterised in that** the intermediate layer (7) is a double-face adhesive strip.

5. Assembly according to one of the preceding claims, **characterised in that** the metallic sole plate (1) is made from aluminium.

6. Device for supplying a motor vehicle discharge lamp, **characterised in that** it has an assembly according to one of the preceding claims.

7. Headlight with a discharge lamp for a motor vehicle, **characterised in that** it has a supply device according to Claim 6.
